# EUROPEAN PATENT APPLICATION

(11) **EP 1 006 583 A1**
(43) Date of publication of application: **07.06.2000**
(21) Application number: 99123865.0
(22) Date of filing: 01.12.1999
(51) Int. Cl.: H01L 27/115, H01L 21/8247

(54) **Ferroelectric memory device and method for manufacturing same**

(30) Priority: 01.12.1998 JP 34132798
(71) Applicant: ROHM CO., LTD., Kyoto (JP)
(72) Inventor: Sameshima, Katsumi, c/o Rohm Co., Ltd., Kyoto (JP)
(74) Representative: Grosse, Wolfgang, Dipl.-Ing.

(57) **Abstract**

A ferroelectric memory device includes a first interlayer film. This first interlayer film has a first contact hole in which a plug is buried by W-CVD. Thereafter, a ferroelectric capacitor, a second interlayer film, etc. are formed on the first interlayer film so that a second contact hole can be formed on the second interlayer film. A second contact hole is formed through the second interlayer film. This second contact hole is filled with a metal interconnection for connection to the plug.

## Description

### BACKGROUND OF THE INVENTION

### Field of the invention

This invention relates generally to a ferroelectric memory device and method for manufacturing same and, more particularly, to a ferroelectric memory device having a contact hole providing plug connection between a lower-level conductor film or conductive diffusion layer and a higher-level metal interconnection, and a method for manufacturing such a ferroelectric memory device.

### Description of the prior art

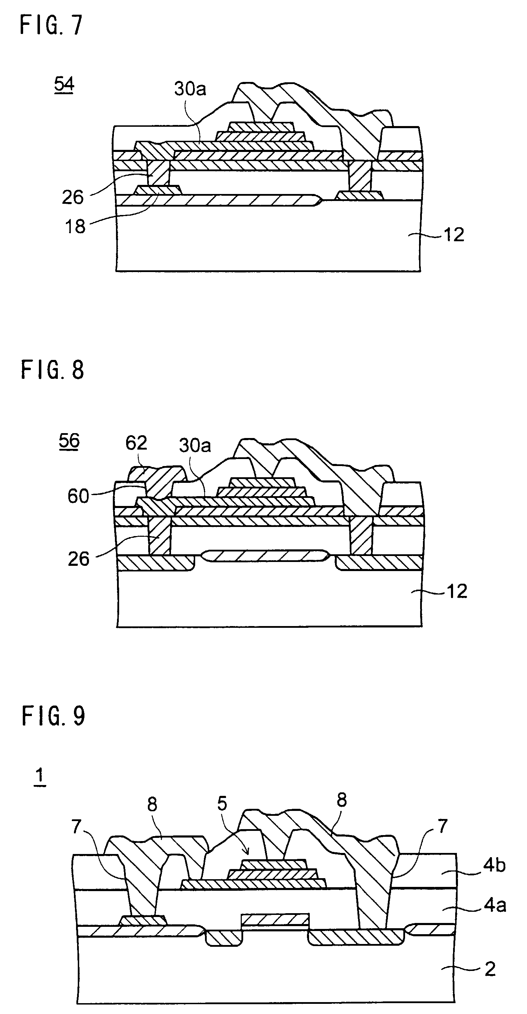

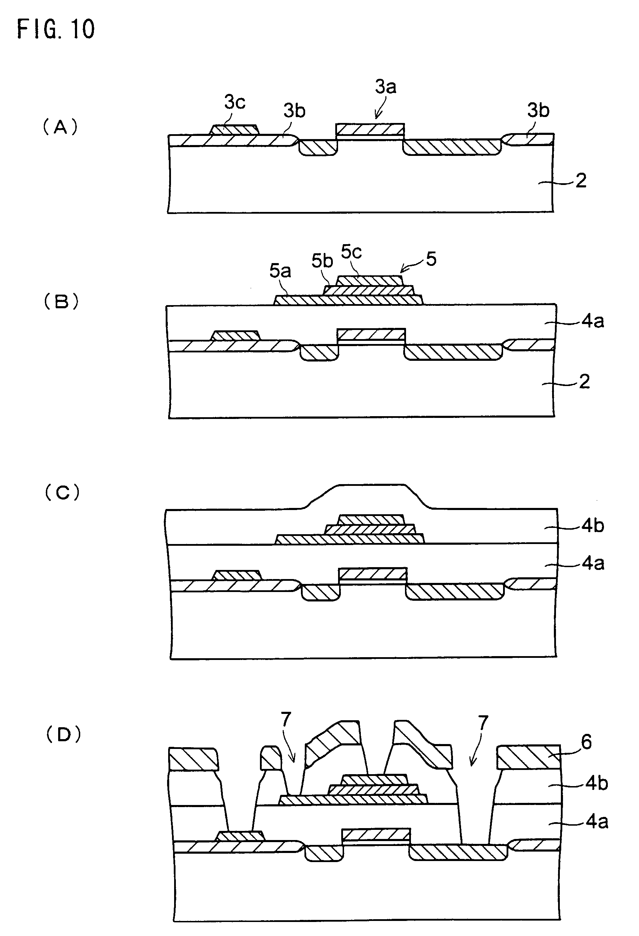

Referring to Figure 9, there is depicted a conventional ferroelectric memory device 1 of this kind, which has been manufactured by a process, for example, as shown in Figure 10. That is, a transistor 3a, a LOCOS oxide film 3b, a conductor film 3c and the like are formed on a semiconductor substrate 2, as shown in Figure 10(A). Thereafter, a first interlayer film 4a as well as a lower electrode 5a, ferroelectric 5b and upper electrode 5c, for constituting a ferroelectric capacitor 5, are formed, as shown in Figure 10(B). Subsequently, as shown in Figure 10(C), a second interlayer film 4b is formed on the first interlayer film 4a in a manner covering the ferroelectric capacitor 5. Then, as shown in Figure 10(D), the second interlayer film 4b is masked by resist 6 to conduct etching on the interlayer films 4a and 4b, thereby forming a contact hole 7 and the like. After removing the resist 6, a metal interconnection 8 is buried inside the contact hole 7 by sputtering or the like to form a plug, as shown in Figure 9.

In the conventional semiconductor device 1, the metal interconnection 8 is buried inside the contact hole 7 having been formed by etching the interlayer films 4a and 4b. Accordingly, the contact hole 7 is made large in aspect ratio, thus posing a problem of poor coverage at a contact area of the metal interconnection 8.

As one means to solve such a problem, it can be considered that wet etching is conducted to provide a taper to an upper portion of a contact hole, thereby improving the coverage of a metal interconnection 8 at the contact area. In such a case, however, there encounters a fear that the ferroelectric capacitor 5 might be deteriorated in characteristic due to hydrogen fluoride produced upon conducting wet etching.

Meanwhile, it can also be considered as another means that tungsten-CVD is conducted to bury the entire contact hole 7 with tungsten thereby reducing the aspect ratio, in order to provide a metal interconnection thereon with improved coverage. In this case, however, there has been a fear that the ferroelectric capacitor 5 be deteriorated in characteristic due to a reducing atmosphere present during W-CVD.

### SUMMARY OF THE INVENTION

It is therefore a primary object of the present invention to provide a ferroelectric memory device which possesses ferroelectric characteristics free from deterioration and improved coverage of metal interconnection in the contact area, and a method for manufacturing same.

The present invention is a ferroelectric memory device having a first interlayer film formed on a semiconductor substrate and a ferroelectric capacitor formed on the first interlayer film, which is characterized in that a contact hole is formed through the first interlayer film to bury therein a plug and a second interlayer film is formed on the first interlayer film.

The present invention is a method for manufacturing a ferroelectric memory device having a semiconductor substrate, an interlayer film formed on the semiconductor substrate, a ferroelectric capacitor formed on the interlayer film and a contact hole formed through the interlayer film, which is characterized in that a plug is buried in a contact hole and thereafter a ferroelectric capacitor is formed.

A contact hole is formed through a first interlayer film on a semiconductor substrate and the contact hole is buried therein with a plug by conducting W-CVD. Thereafter, a ferroelectric capacitor is formed on the first interlayer film and further a metal interconnection or ferroelectric capacitor electrode is connected to the plug. Consequently, the metal interconnection is improved of coverage in a contact area as compared to that of the prior art wherein a plug is formed by burying only a metal interconnection in a contact hole. Also, because the plug is buried in the contact hole before forming a ferroelectric capacitor, there encounters no deterioration of ferroelectric characteristics due to a reducing atmosphere upon conducting CVD.

If a second interlayer film is formed on a first interlayer film through an etch stop layer, when etching the second interlayer film to form a second contact hole communicating with the first contact hole, the plug and etch stop layer serve to block etching from proceeding onto the first interlayer. It is therefore possible to form through the second interlayer film a contact hole with a lager diameter than that of a contact hole formed through the first interlayer film. Thus, the second contact hole can be filled by a sufficient coverage of a metal interconnection, even for a case of device scale down.

According to the invention, it is possible to prevent a ferroelectric from deteriorating in characteristic. Further, the metal interconnection can be improved in coverage in a contact area.

The above described objects and other objects, features, aspects and advantages of the present invention will become more apparent from the following detailed description of the present invention when taken in conjunction with the accompanying drawings.

### BRIEF DESCRIPTION OF THE DRAWINGS

Figure 1 is an illustrative view showing one embodiment of the present invention;
Figure 2 is an illustrative view showing a method for manufacturing the Figure 1 embodiment;
Figure 3 is an illustrative view showing the manufacturing method of the Figure 1 embodiment;
Figure 4 is an illustrative view showing another embodiment of the invention;
Figure 5 is an illustrative view showing another embodiment of the invention;
Figure 6 is an illustrative view showing another embodiment of the invention;
Figure 7 is an illustrative view showing another embodiment of the invention;
Figure 8 is an illustrative view showing another embodiment of the invention;
Figure 9 is an illustrative view showing a prior art; and
Figure 10 is an illustrative view showing a method for manufacturing a conventional ferroelectric memory device.

### DETAILED DESCRIPTION OF THE PREFERRED EMBODIMENTS

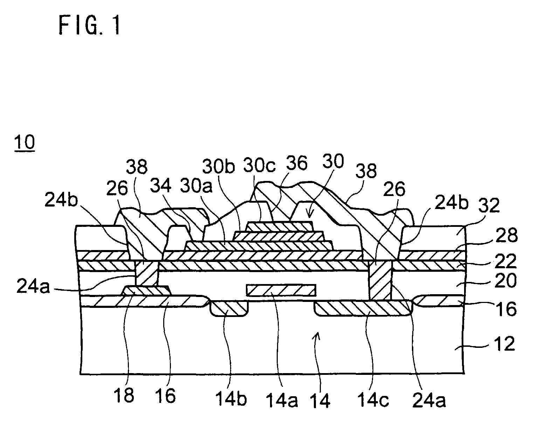

Referring to Figure 1, there is depicted a ferroelectric memory device 10 of this embodiment which includes a semiconductor substrate 12. On the semiconductor substrate 12 are formed a transistor 14 including gate 14a, source 14b and drain 14c, a LOCOS oxide film 16, a conductor film 18 and so on. A first interlayer film 20 and an etch stop layer 22 are formed in a manner covering these elements. A first contact hole 24a is formed through the first interlayer film 20 and etch stop layer 22, so that a plug 26 can be buried in the first contact hole 24a. A stress relaxing layer 28 as well as a ferroelectric capacitor 30 including a lower electrode 30a, ferroelectric 30b and upper electrode 30c are formed on the etch stop layer 22. A second interlayer 32c is formed in a manner covering these elements. Furthermore, a second contact hole 24b, a contact hole 34 and a contact hole 36 are formed through the stress relaxing layer 28 and second interlayer film 32, which respectively communicate with the first contact hole 24a, the lower electrode 30a and the upper electrode 30c. These contact holes 24b, 34 and 36 are buried with metal interconnections 38.

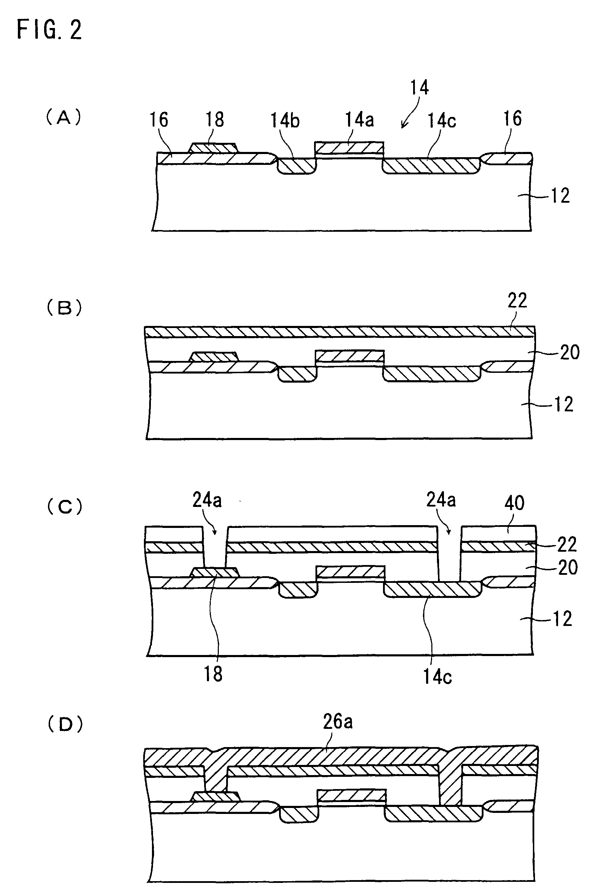

A method for manufacturing a ferroelectric memory device 10 will now be explained concretely, with reference to Figure 2 to Figure 3. First, on a semiconductor substrate 12 of silicon (Si) or the like are formed a transistor 14 including a gate 14a, source 14b and drain 14c, a LOCOS oxide film 16 and a conductor film 18 of polysilicon (Poly-Si), tungsten-silicon (WSi) or the like, as shown in Figure 2(A).

Then, as shown in Figure 2(B), a first interlayer film 20 is formed by CVD or the like in a manner covering these elements, which may be of silicate glass containing phosphorus (PSG), silicate glass containing boron/phosphorus (BPSG), undoped silicate glass (USG) or the like. Then, an etch stop layer 22 is formed of silicon nitride (SiN), silicon nitride oxide (SiON) or the like on the first interlayer film 20 by CVD or the like.

Subsequently, as shown in Figure 2(C), the etch stop layer 22 and first interlayer film 20 are masked with patterned resist 38 and etched to provide contact holes 24a respectively reaching the drain 14c and the conductor film 18.

After removing the resist 40, the first contact holes 24a is buried with a contact film 26a of tungsten or the like by CVD to provide plugs as shown in Figure 2(D). Despite there exists a reducing atmosphere upon implementing CVD, a ferroelectric 30b is not yet formed at the present time point. Consequently, there encounters no deterioration in ferroelectric 30b characteristics due to a reducing atmosphere.

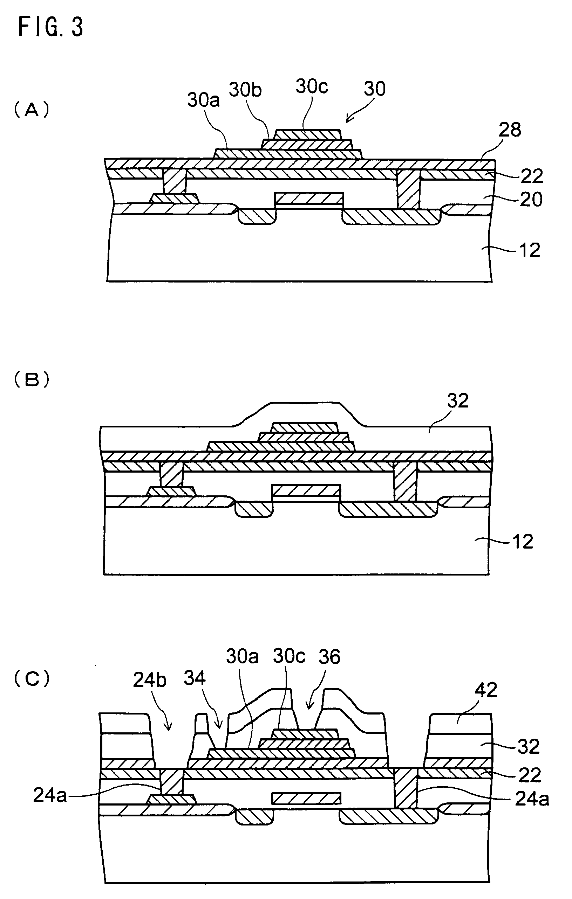

Then, the contact film 26a in other regions than the first contact holes 24a is removed by being etched back. Thereafter, on the etch stop layer 22 are formed, as shown in Figure 3(A), a stress relaxing layer 28 of phosphorus-containing silicate glass (PSG), boron/phosphorus-containing silicate glass (BPSG) or undoped silicate glass (USG), a lower electrode 30a of iridium or the like, a ferroelectric 30b of PZT or PLZT and an upper electrode 30c of iridium or the like, in this order.

Furthermore, as shown in Figure 3(B), a second interlayer film 32 is formed of phosphorus-containing silicate glass (PSG), boron/phosphorus-containing silicate glass (BPSG) or undoped silicate glass (USG). During or after the manufacture process, these layers possibly suffer from stresses caused by a difference in thermal extension coefficient or the like. Such stresses, if occur, are relaxed by the stress relaxing layer 28. Accordingly, the ferroelectric capacitor 30 will not suffer deterioration of characteristic due to stresses.

Then, as shown in Figure 3(C), the second interlayer film 32 and stress relaxing layer 28 are masked by patterned resist 42, and then etched to have a second contact hole 24b and contact holes 34 and 36 respectively communicating with the first contact hole 24a, the lower electrode 30a and the upper electrode 30c. In this case, the etch gas or solution is selected of kind such that the etch rate of the plug 26 and etch stop layer 22 is lower than that of the second interlayer film 32 and stress relaxing layer 28. Consequently, even if the second contact hole 24b is made greater in diameter than that of the first contact hole 24a, a step will be formed at a boundary between the plug 26 and the etch stop layer 22, thus preventing against poor metal coverage. It is therefore possible to form a metal interconnection 38 with sufficient coverage even for a case of device scale down.

After removing the resist 42, metal interconnections 38 are formed of copper (Cu), aluminum (Al) or the like by sputtering or the like in predetermined positions on the second interlayer film 32, in a manner filling the second contact hole 24b and contact holes 34 and 36, as shown in Figure 1. Thus, the lower electrode 30a and the upper electrode 30c are respectively connected to the conductor film 18 and the drain 14c through the plugs 26.

According to this embodiment, the aspect ratio is reduced by burying the plug 26 inside the first contact hole 24a so that the metal interconnection 38 can be connected with the top end of the plug 26. Accordingly, the metal interconnection 38 is improved in coverage in the contact area, as compared to the prior art wherein only the metal interconnection 38 is buried in the contact holes 24a and 24b. Also, by burying the plug 26 in the first contact hole 24a, it is possible to make the contact holes 24b, 34 and 36 with a smaller depth difference. Due to this, these contact holes 24b, 34 and 36 can be simultaneously filled by metal interconnections 38.

Also, the plug 26 is buried in the first contact hole 24a before forming a ferroelectric 30b. Consequently, the ferroelectric 30b will not be deteriorated in characteristic by a reducing atmosphere upon performing CVD.

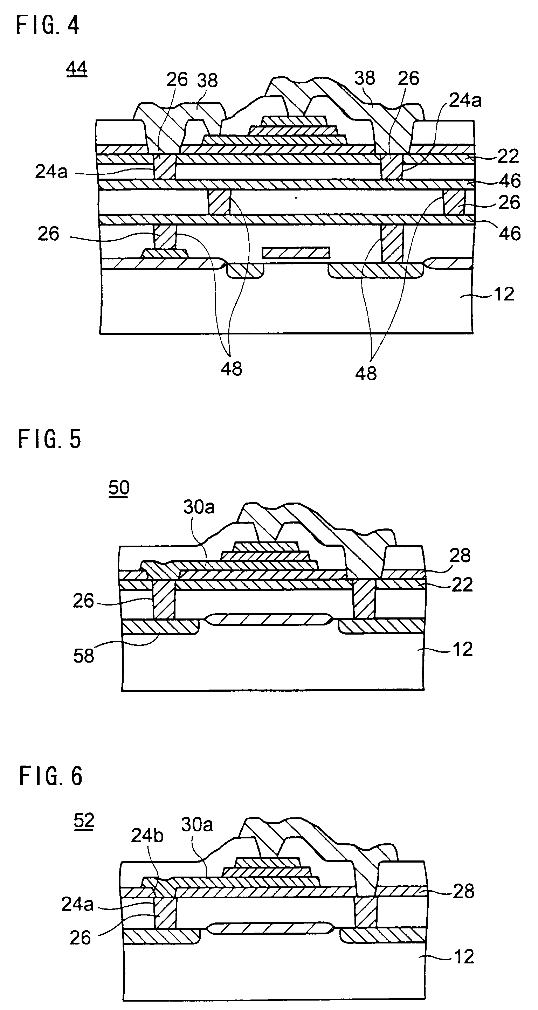

Incidentally, although the above embodiment showed a ferroelectric memory device 10 having a single-layered interconnect structure, the invention is applicable also to a ferroelectric memory device 44 having a multilevel interconnect structure as shown in Figure 4. In this case, at least one levels of interconnections 46 are formed between a conductive substrate 12 and an etch stop layer 22. These interconnect layers 46 are connected with upper or lower levels of interconnections 46 or metal interconnections 38 via plugs 26 buried in contact holes 48 or 24a.

The lower electrode 30a may be connected directly to the plug 26, as in a ferroelectric memory device 50, 52, 54 and 56 shown in Figure 5 to Figure 8.

That is, the ferroelectric memory device 50 shown in Figure 5 has a lower electrode 30a directly connected to a top surface of a plug 26, thereby connecting the lower electrode 30a to a diffusion layer 58 formed in a semiconductor substrate 12.

The ferroelectric memory device 52 shown in Figure 6, with a structure eliminated of the etch stop layer 22 from the ferroelectric memory device 50 (Figure 5), has a second contact hole 24b made smaller in diameter than that of a first contact hole 24a so that a plug 26 can serve as an etch stop.

Meanwhile, the ferroelectric memory device 54 shown in Figure 7 has a lower electrode 30a connected directly to a top surface of a plug 26, thereby connecting the lower electrode 30a to a conductor film 18 formed on a LOCOS film 16.

The ferroelectric memory device 56 shown in Figure 8 has lower electrode 30a connected to a top end of a plug 26 and further contact via hole 60 formed thereon so that the contact via hole 60 can be filled by a metal interconnection 62. According to these embodiments (Figure 5 to Figure 8), there is no necessity to form on a second interlayer film 32 a metal interconnection 38 to connect between a lower electrode 30a and a plug 26, thereby reducing a size of the entire device.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A ferroelectric device, comprising:
a semiconductor substrate;
first interlayer film formed on said semiconductor substrate;
a first contact hole formed through said first interlayer film;
a plug buried in said first contact hole;
a second interlayer film formed on said first interlayer film; and
a ferroelectric capacitor formed on said second interlayer film.

2. A ferroelectric memory device according to claim 1, wherein said plug includes tungsten deposited by CVD.

3. A ferroelectric memory device according to claim 1 or 2, further comprising a transistor formed on said semiconductor substrate.

4. A ferroelectric memory device according to claim 3, wherein said transistor includes a diffusion layer, and said plug having a lower end connected to said diffusion layer.

5. A ferroelectric memory device according to any of claims 1 to 3, wherein said plug has a lower end connected to a conductor film.

6. A ferroelectric memory device according to any of claims 1 to 5, further comprising an etch stop layer formed between said first interlayer film and said second interlayer film and having an etch rate lower than an etch rate on said second interlayer film.

7. A ferroelectric memory device according to claim 6, further comprising a stress relaxing layer formed between said etch stop layer and said ferroelectric capacitor.

8. A ferroelectric memory device according to claim 7, wherein said stress relaxing layer is formed by an oxide film.

9. A ferroelectric memory device according to any of claims 6 to 8, further comprising at least one layer of an interconnection formed between said semiconductor substrate and said etch stop layer.

10. A ferroelectric memory device according to any of claims 1 to 9, further comprising a second contact hole formed through said second interlayer film to communicate with said first contact hole, and a metal interconnection buried in said second contact hole.

11. A ferroelectric memory device according to any of claims 1 to 10, wherein said ferroelectric capacitor has an electrode directly connected to said plug.

12. A ferroelectric memory device according to claim 11, wherein said plug has a top end connected with said electrode, further comprising a stack via hole formed on said electrode.

13. A method for manufacturing a ferroelectric memory device, comprising steps of:
(a) forming an interlayer film on a semiconductor substrate;
(b) forming a contact hole through said interlayer film;
(c) burying a plug in said contact holes; and
(d) forming a ferroelectric capacitor on said interlayer film.

14. A manufacturing method according to claim 13, wherein in said step (c) said plug is formed by a CVD method.

15. A manufacturing method according to claim 13 or 14, wherein in said step (a) a first interlayer film is formed on said semiconductor substrate, in said step (b) a first contact hole is formed through said first interlayer film, in said step (c) said plug is buried in said first contact hole, in said step (d) said ferroelectric capacitor and a second interlayer film covering same are formed on said first interlayer film, further comprising:
(e) forming through second interlayer film second and third contact holes respectively communicating with said first contact hole and said ferroelectric capacitor, and
(f) burying metal interconnections in said second and third contact holes to connect between said ferroelectric capacitor and said plug.

16. A manufacturing method according to claim 15, further comprising (g) forming on said first interlayer film an etch stop layer having an etch rate lower than an etch rate on said second interlayer film, wherein after said step (g) said first contact hole is formed between said first interlayer film and said etch stop layer.

17. A manufacturing method according to claim 13 or 14, wherein said in said step (a) a first interlayer film is formed on said semiconductor substrate, in said step (b) a first contact hole is formed through said first interlayer film, in said step (c) said plug is buried in said first contact hole, and in said step (d) said ferroelectric capacitor is formed on said first interlayer film and further an electrode of said ferroelectric capacitor is directly connected to said plug.
